# EUROPEAN PATENT APPLICATION

(11) **EP 1 734 595 A2**
(43) Date of publication of application: **20.12.2006**
(21) Application number: 06253092.8
(22) Date of filing: 14.06.2006
(51) Int. Cl.: H01L 51/42

(54) **Dye-sensitized multilayer solar cell**

(30) Priority: 14.06.2005 JP 2005173240
(71) Applicant: SEIKO EPSON CORPORATION, Tokyo 160-0811 (JP)
(72) Inventor: Miyazawa, Takashi, c/o Seiko Epson Corporation, Shiojiri-shi Nagano-ken 399-0785 (JP)
(74) Representative: Cloughley, Peter Andrew

(57) **Abstract**

A multilayer structure comprises a base, a first film, a second film including a plurality of first structure units, and a third film including a plurality of second structure units. The first film is disposed between the second film and the third film. The second film is disposed between the base and the first film. The first film is chemically bonded to one of at least one first structure units out of the plurality of first structure units and at least one second structure units out of the plurality of second structure units. Electron transfer occurs between the second film and the third film in response to energy applied.

## Description

The present invention relates to a multilayer structure, a photoelectric conversion element, and an electronic apparatus.

A silicon photoelectric conversion element, a so-called solar cell, has attracted attention as an environmentally-friendly power source. Among silicon solar cell types, there is a single-crystal silicon solar cell that is applied to an artificial satellite, for example. As more practical examples, a polycrystalline silicon solar cell and an amorphous silicon solar cell particularly have come to be available for industrial and household use.

These types of silicon solar cells, however, require high manufacturing cost and energy, making them not necessarily environmentally friendly as power sources.

As a next-generation solar cell replacing these types, there has been proposed a dye-sensitized solar cell that is considered to be produced with low manufacturing cost and energy. JP-A-1-220380 is an example of related art.

The dye-sensitized solar cell, however, has not been practically used due to its low photoelectric conversion efficiency.

To solve this problem, there has been proposed a technology for improving the photoelectric conversion efficiency of a dye-sensitized solar cell by using a nanotube crystalline titania (titania nanotube) material that is suitably applicable for a photocatalyst or the like. JP-A-2004-146663 is an example of

### related art.

However, manufacturing of high-quality nanotube crystalline titania that is suitable for a solar cell involves many technical and cost-related problems.

An advantage of the present invention is to provide a photoelectric conversion element capable of achieving practical photoelectric conversion efficiency by prolonging the life of a charge separation state after electron transfer, and to provide a highly reliable electronic apparatus including the photoelectric conversion element.

A multilayer structure according to one aspect of the invention includes a base, a first film, a second film including a plurality of first structure units, and a third film including a plurality of second structure units. The first film is disposed between the second film and the third film, while the second film is disposed between the base and the first film. The first film is chemically bonded to one of at least one first structure units out of the plurality of first structure units and at least one second structure units out of the plurality of second structure units. Electron transfer occurs between the second film and the third film in response to energy applied.

Accordingly, for example, the multilayer structure can restrict reverse electron transfer and the transmission of any chemical species that capture radical ions and other intermediates produced in response to energy applied by light, electricity, heat, radiation, elementary particle beams, or the like. It is therefore possible to contribute to prolonging the life of a charge separation state.

A multilayer structure according to another aspect of the invention includes a base, a first film covering the base, a plurality of first structure units disposed between the base and the first film, and a plurality of second structure units. The first film is disposed between the plurality of first structure units and the plurality of second structure units. Electron transfer occurs between the base and at least one of at least one first structure units out of the plurality of first structure units and at least one second structure units out of the plurality of second structure units in response to energy applied.

The electron transfer between the base and at least one of the at least one first structure units and the at least one second structure units may be via the other structure units or a different structure unit. For example, if electrons transfer from the at least second structure units to the base, they may go through any of the plurality of first structure units, or another structure unit that is different from the plurality of first structure units may be used as an intermediate electron acceptor.

In the above-described multilayer structure, for example, if electrons transfer between the at least one first structure units and the base, an intermediate, such as an anion radical and a cation radical, of the at least one first structure units may be formed because of the electron transfer. In such a case, the first film can restrict the transmission of any chemical species that capture the intermediate, since the at least one first structure units is disposed between the base and the first film.

In the above-described multilayer structure, for example, if electrons transfer between the at least one second structure units and the base, an intermediate, such as an anion radical and a cation radical, of the at least one second structure units may be formed because of the electron transfer. In such a case, the first film can restrict reverse electron transfer to the intermediate of the at least one second structure. This is because the first film prohibits the plurality of second structure units and the base from becoming adjacent to each other, for example.

Furthermore, if electrons transfer between the at least one second structure units and the base via any of the plurality of first structure units, an intermediate, such as an anion radical and a cation radical, of any of the plurality of first structure units may be formed.

In such a case, the first film can restrict the transmission of any chemical species that capture the intermediate, for example. It is therefore possible to prolong the life of a charge separation state.

It is preferable in the above-described multilayer structure that the first film have a function to restrict an electron moving from one of the second film and the third film to the other film as the electron transfer from moving from the other film to the one film.

Accordingly, for example, speed of reverse electron transfer, i.e., speed of electron transfer from the second film side to the third film side, can be lowered. It is therefore difficult for the electron to move in a reverse direction, and thus possible to enhance the photoelectric conversion efficiency of a solar cell.

It is preferable in the above-described multilayer structure that at least one of the plurality of first structure units and the plurality of second structure units be chemically bonded to the first film.

Accordingly, for example, this bonding can be stronger.

It is preferable in the above-described multilayer structure that the bonding be a covalent bonding.

Accordingly, for example, the bonding can be stronger.

It is preferable in the above-described multilayer structure that the base include at least one of a semiconductor material and a metal material.

For example, by appropriately selecting a bonding group, any of the above-mentioned materials and the bonding group can be bonded more strongly.

It is preferable in the above-described multilayer structure that the plurality of first structure units be bonded to the base with a bonding group therebetween.

Accordingly, for example, the first structure units can be bonded to the base more strongly.

It is preferable in the above-described multilayer structure that the first film be provided by polymerizing at least one of a polymerization group bonded to one of the plurality of first structure units and a polymerization group bonded to one of the second structure units.

Accordingly, for example, the first film chemically bonded to the first structure units can be easily provided.

It is preferable that the above-described multilayer structure further include a fourth film, and the plurality of second structure units be disposed between the fourth film and the first film.

Accordingly, for example, the film made of a fine polymer can prevent the first film, the second film, the third film, and the base from coming in contact with moisture more surely. It is therefore possible to restrict aging deterioration of the first film, the second film, the third film, and the base and to prolong the life of a photoelectric conversion element.

It is preferable that the above-described multilayer structure further include a plurality of polar groups, and the fourth film be disposed between the plurality of polar groups and the plurality of second structure units.

Accordingly, for example, it is possible to enhance the electron transfer efficiency of a photoelectric conversion layer to an electrolyte.

It is preferable in the above-described multilayer structure that one of each of the plurality of first structure units and each of the plurality of second structure units include a metal complex.

For example, the metal complex may have a relatively wide range of wavelengths of light that can be absorbed and also have an excellent photosensitization property.

A photoelectric conversion element according to yet another aspect of the invention includes the above-described multilayer structure.

Accordingly, for example, it is possible to provide the photoelectric conversion element having a high photoelectric conversion efficiency.

A photoelectric conversion element according still another aspect of the invention includes the above-described multilayer structure, and the base does one of the following: providing at least one of the plurality of first structure units and the plurality of second structure units with an electron in response to light applied to the photoelectric conversion element, and receiving an electron from at least one of the plurality of first structure units and the plurality of second structure units in response to light applied to the photoelectric conversion element.

Accordingly, for example, it is possible to provide the photoelectric conversion element having a high photoelectric conversion efficiency.

It is preferable in the above-described photoelectric conversion element that the base include an electrode.

Accordingly, for example, it is possible to omit an electron transport layer and provide the photoelectric conversion element with a simplified structure by a simplified manufacturing process.

It is preferable in the above-described photoelectric conversion element that the base include a carrier transport part between the electrode and the plurality of first structure units.

Accordingly, for example, it is possible to enhance the photoelectric conversion efficiency of the photoelectric conversion element.

An electronic apparatus according to still another aspect of the invention includes the above-described photoelectric conversion element.

Accordingly, it is possible to provide the electronic apparatus that is highly reliable.

It is preferable in the above-described multilayer structure that the bonding group be at least one of a thiol group, a sulfonate group, a carboxyl group, and a tertiary amino group.

For example, these bonding groups can be bonded to the semiconductor or metal material more strongly. In other words, a photoelectric conversion layer and an electron transport layer can be spatially close to each other with these bonding groups therebetween, making the electron transfer between the photoelectric conversion layer and the electron transport layer occur efficiently. Electrons can be further transferred from the electron transport layer to the electrode.

It is preferable in the above-described multilayer structure that the polymerization group be an unsaturated hydrocarbon group capable of being radically polymerized.

Accordingly, for example, it is possible to convert the polymerization group to a polymer more easily.

It is preferable in the above-described multilayer structure that the fourth film be provided by polymerizing a polymerization group bonded to each of a plurality of third structure units and a polymerization group bonded to each of a plurality of fourth structure units.

Accordingly, for example, the fourth film can be bonded to the third structure units and the fourth structure units strongly.

It is preferable in the above-described multilayer structure that the metal complex be one of a ruthenium complex and an iron complex.

For example, these complexes that have a particularly excellent photosensitization property and relatively high chemical stability can be used.

It is preferable in the above-described multilayer structure that the first structure units have an electron acceptor that accepts an electron.

Accordingly, for example, electrons can move at higher speed. It is therefore possible to enhance the photoelectric conversion efficiency of the photoelectric conversion element.

It is preferable in the above-described multilayer structure that the electron acceptor have a structure represented by the following formula (1).

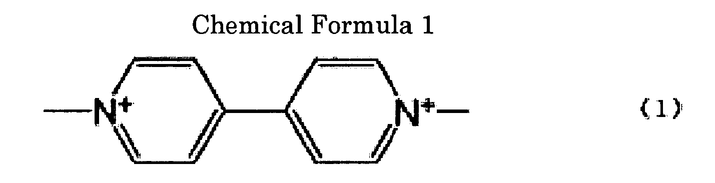

For example, since the structure represented by the above formula (1) has a particularly excellent electron-accepting property, electrons can move from the second film to the base side at particularly high speed.

The invention will be described by way of example only with reference to the accompanying drawings, wherein like numbers reference like elements.

Fig. 1 is a partial sectional view showing a first embodiment of a photoelectric conversion element according to the invention that is applied to a dye-sensitized solar cell.

Fig. 2 is an enlarged view showing a central section of the dye-sensitized solar cell of Fig. 1 in its thickness direction.

Fig. 3 is a schematic showing the structure of an electron transport layer and a photoelectric conversion layer.

Fig. 4 is a schematic showing the first embodiment of a multilayer structure according to the invention.

Figs. 5A to 5C are schematics for describing a method for manufacturing the multilayer structure of Fig. 4.

Fig. 6 is a schematic showing a second embodiment of the multilayer structure according to the invention.

Fig. 7 is a schematic showing a third embodiment of the multilayer structure according to the invention.

Fig. 8 is a schematic showing a fourth embodiment of the multilayer structure according to the invention.

Fig. 9 is a plan view showing a calculator to which the electronic apparatus according to one embodiment of the invention is applied.

Fig. 10 is a perspective view showing a cellular phone (including a personal handyphone system) to which the electronic apparatus according to one embodiment of the invention is applied.

Exemplary embodiments of a multilayer structure, a photoelectric conversion element, and an electronic apparatus according to the present invention will be described with reference to the accompanying drawings.

### First Embodiment

A first embodiment of a multilayer structure and a photoelectric conversion element according to the invention will now be described.

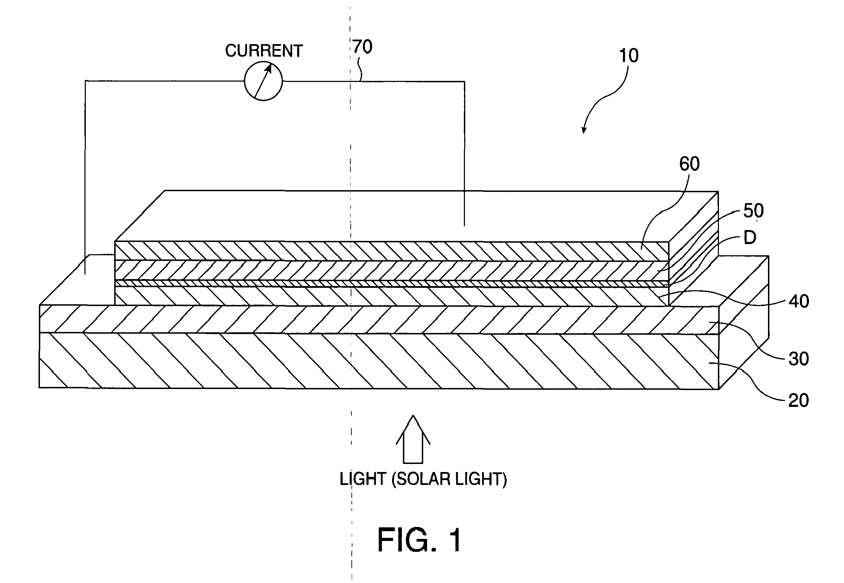

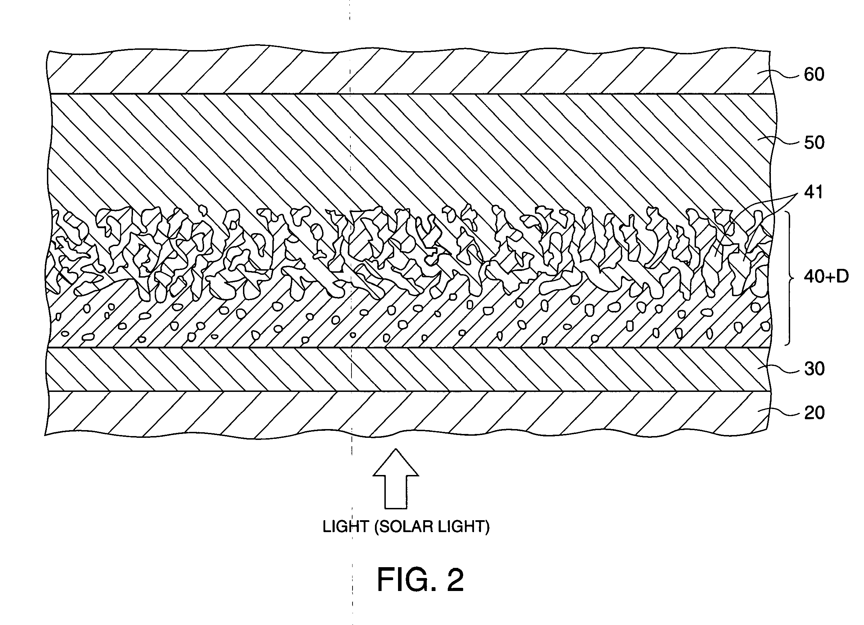

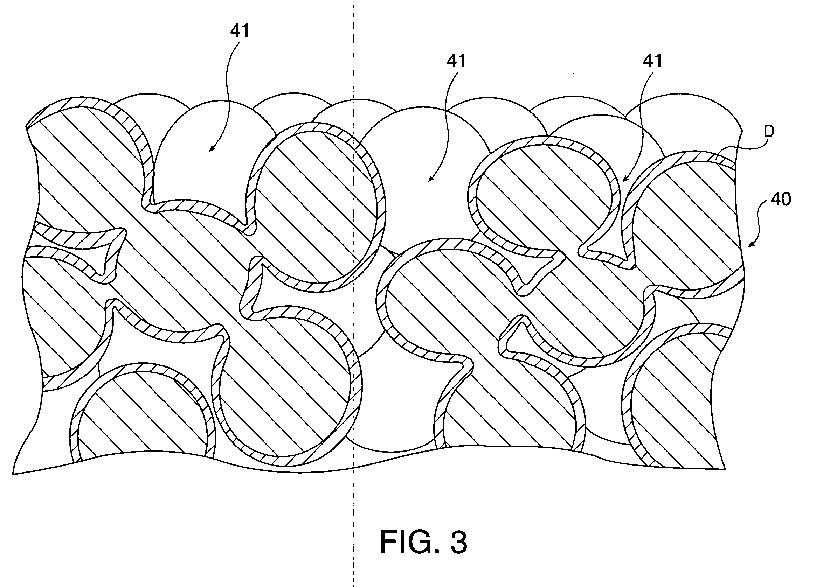

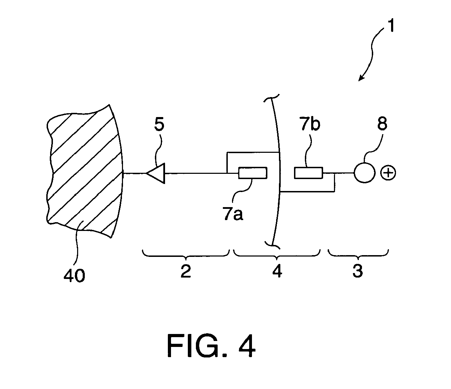

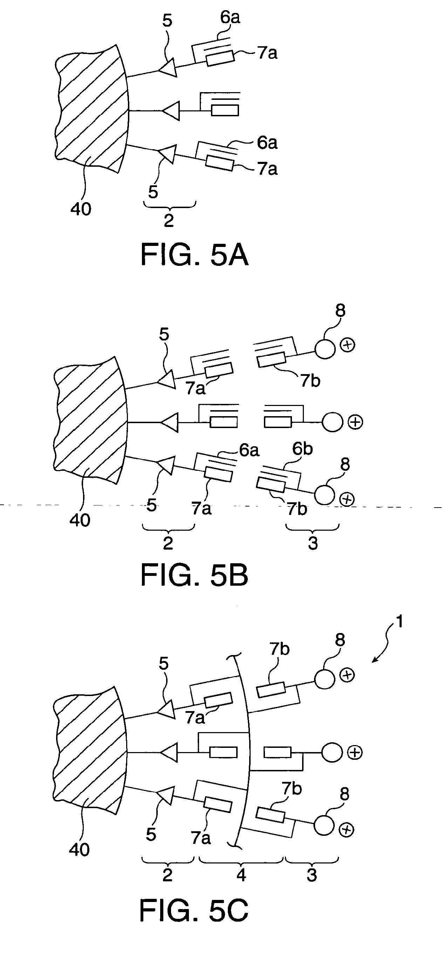

Fig. 1 is a partial sectional view showing the first embodiment of the photoelectric conversion element according to the invention that is applied to a dye-sensitized solar cell. Fig. 2 is an enlarged view showing a central section of the dye-sensitized solar cell of Fig. 1 in its thickness direction. Fig. 3 is a schematic showing the structure of an electron transport layer and a photoelectric conversion layer. Fig. 4 is a schematic showing the first embodiment of the multilayer structure according to the invention. Figs. 5A to 5C are schematics for describing a method for manufacturing the multilayer structure of Fig. 4.

Referring to Fig. 1, this dye-sensitized solar cell (photoelectric conversion element according to an aspect of the invention) 10 includes a first electrode 30, a second electrode 60 placed face to face with the first electrode 30, an electron transport layer 40 placed between them and serving as a carrier transport layer (carrier transport part), a photoelectric conversion layer D placed in contact with the electron transport layer 40, and a hole transport layer 50 placed between the electron transport layer 40 and the second electrode 60 and in contact with the photoelectric conversion layer D.

The dye-sensitized solar cell 10 (hereinafter simply referred to as the "solar cell") 10 is provided on a substrate 20.

Each of the components will now be described. In the following description, the upper side of each layer shown in Fig. 1 is referred to as the "upper side", while the lower side thereof is referred to as the "lower side".

The substrate 20 is made of a flat-plate material to support the first electrode 30, the electron transport layer (base) 40, the photoelectric conversion layer D, the hole transport layer 50, and the second electrode 60. While the above-described base corresponds to the electron transport layer 40, which will be described in greater detail, in the present embodiment, the electron transport layer 40 can be omitted. In this case, the base corresponds to the first electrode (electrode) 30.

The solar cell 10 of the present embodiment receives light such as solar light (hereinafter simply referred to as the "light") that is incident (emitted) on the side of the substrate 20 and the first electrode 30, which will be described below, as shown in Fig. 1. It is therefore preferable that the substrate 20 and the first electrode 30 have a sufficient transmission of the light that is incident on them, or be substantially transparent (colorless and transparent, colored and transparent, or translucent). Accordingly, the light can efficiently reach the photoelectric conversion layer D, which will be described below.

Examples of materials of the substrate 20 may include: glass, ceramics, polycarbonate (PC), polyethylene terephthalate (PET) and other resin materials, aluminum and other metal materials.

An average thickness of the substrate 20 is not limited and set appropriately depending on its materials, applications of the solar cell 10, and so forth, as described below, for example.

When the substrate 20 is made of a solid material, its average thickness is preferably about 0.1 to 1.5 mm, and more preferably about 0.8 to 1.2 mm. When the substrate 20 is made of a flexible material, its average thickness is preferably about 0.5 to 150.0 µm, and more preferably about 10.0 to 75.0 µm.

Provided on the substrate 20 (on one side of the substrate 20) is the first electrode 30. The first electrode 30 receives carriers (electric charges) produced in the photoelectric conversion layer D, which will be described below, via the electron transport layer 40, and transfers them to an external circuit 70 coupled thereto.

In the present embodiment, it is assumed that the carriers are electrons as an example.

Examples of materials of the first electrode 30 may include: metal oxide materials such as indium tin oxide (ITO), fluorine-doped tin oxide (FTO), indium oxide (IO) and tin oxide (SnO₂); metal materials of aluminum, nickel, cobalt, platinum, silver, gold, copper, molybdenum, titanium and tantalum or their alloys; and carbon materials such as graphite. They may be used singly or in combination (e.g., as a multilayer structure of multiple layers).

An average thickness of the first electrode 30 is not limited and set appropriately depending on its materials, applications of the solar cell 10, and so forth, as described below, for example.

When the first electrode 30 is made of a metal oxide material (transparent conductive metal oxide material), its average thickness is preferably about 0.05 to 5.00 µm, and more preferably about 0.10 to 1.50 µm. When the first electrode 30 is made of a metal or carbon material, its average thickness is preferably about 0.01 to 1.00 µm, and more preferably about 0.03 to 0.10 µm.

The shape of the first electrode 30 is not limited to what is shown in the drawing, and may be like multiple combs, for example. In this case, the light passes through between the multiple combs before reaching the photoelectric conversion layer D. Therefore, the first electrode 30 is not necessarily substantially transparent. This means that the first electrode 30 can be manufactured with greater versatility in terms of materials and manufacturing methods.

Furthermore, the first electrode 30 may include a combination of such comb-like electrodes and layer electrodes (by multilayering the electrodes, for example).

Provided on the first electrode 30 is the electron transport layer 40.

The electron transport layer 40 receives electrons produced in the photoelectric conversion layer D at least, and transfers them to the first electrode 30. Accordingly, the photoelectric conversion efficiency of the solar cell 10 can be enhanced.

It is preferable that the electron transport layer 40 be made of at least one of a semiconductor material and a metal material. By appropriately selecting a bonding group that will be described later, any of these materials and the bonding group can be bonded strongly. In other words, the photoelectric conversion layer D and the electron transport layer 40 can be spatially close to each other with the bonding group therebetween, making electron transfer between the photoelectric conversion layer D and the electron transport layer 40 occur efficiently. The electrons are further transferred from the electron transport layer 40 to the first electrode 30.

The semiconductor material may be appropriately selected from the following materials: oxide semiconductor materials such as titanium dioxide (TiO₂), titanium oxide (TiO), dititanium trioxide (Ti₂O₃) and other titanium oxides, zinc oxide (ZnO), tin oxide (SnO₂), niobium pentoxide (Nb₂O₅), tungsten trioxide (WO₃), silicon dioxide (SiO₂), nickel oxide (NiO), and cerium oxide (CeO₂); element semiconductor materials of silicon or germanium; and chemical semiconductor materials such as gallium nitride, indium phosphide, and zinc sulfide. They may be used singly or in combination.

Examples of the metal materials may include gold, silver, and platinum. They may be used singly or in combination.

Among others, it is preferable that the electron transport layer 40 be primarily made of titanium dioxide from a cost and stability perspective, for example.

Since titanium dioxide has a relatively stable crystal structure, the electron transport layer 40 primarily made of titanium dioxide is advantageous in that it has little aging deterioration and long-life stable performance even under a harsh environment.

Furthermore, titanium dioxide may have an anatase or rutile crystal structure as its primary component, or a mix of the both.

If rutile titanium dioxide and anatase titanium dioxide are mixed, the mix ratio by weight is preferably, but not limited to, about 95:5 to 5:95, and more preferably about 80:20 to 20:80.

The electron transport layer 40 is composed of particles, tubular bodies, or a mix of the both, for example, of the above-mentioned oxide semiconductor materials.

In particular, using the tubular bodies can increase the speed of electron transmission in the electron transport layer 40. In addition, it is possible to increase the specific surface area of the electron transport layer 40, and thus increase the bonding amount of pigments. Accordingly, the power generation efficiency of the solar cell 10 can be further enhanced.

If the particles are used, their mean diameter is preferably about 1 nm to 1 µm, and more preferably about 5 to 50 nm. If the tubular bodies are used, their mean length is preferably within such a range. It is therefore possible to further enhance the above-described effects.

It is also preferable, at an interface between the particles, between the tubular bodies, or between the particles and the tubular bodies, that they be sufficiently dispersed. Accordingly, it is possible to prevent electron transfer in the electron transport layer 40 from being restricted, and surely prevent or restrict electron-hole recombination.

This can be achieved, for example, by melting surface and adjacent portions of the particles or the tubular bodies after the electron transport layer 40 is provided, and then reburning the electron transport layer 40 at about 400 to 500 degrees Celsius.

To melt the surface and adjacent portions of the particles or the tubular bodies, an acid solution, such as hydrochloric acid, nitric acid, acetic acid, and hydrofluoric acid, or an alkaline solution containing sodium hydroxide, magnesium hydroxide, or potassium hydroxide, for example, can be used.

The porosity of the electron transport layer 40 is not particularly limited, but preferably about 5% to 90%, more preferably about 15% to 50%, and further preferably about 20% to 40%. When the porosity of the electron transport layer 40 is within such a range, it is possible to make the specific surface area of the electron transport layer 40 sufficiently large. Consequently, it is possible to make an area of the photoelectric conversion layer D, which will be described later, to be provided on the outer surface of the electron transport layer 40 and the inner surface of a pore 41 sufficiently large. It is therefore possible to produce a sufficient amount of electrons in the photoelectric conversion layer D and transfer the electrons to the electron transport layer 40 efficiently. Accordingly, the power generation efficiency of the solar cell 10 can be further enhanced.

The average thickness of the electron transport layer 40 is not particularly limited, but preferably about 0.1 to 300.0 µm, more preferably about 0.5 to 100.0 µm, and further preferably about 1.0 to 25.0 µm.

Provided in contact with the electron transport layer 40 is the photoelectric conversion layer D. The photoelectric conversion layer D and the electron transport layer (base) 40 make up a multilayer structure (multilayer structure according to an aspect of the invention) 1.

The multilayer structure 1 will now be described.

Upon receiving an optical stimulus from light, the photoelectric conversion layer D provides the electron transport layer with electrons. Referring to Fig. 3, the photoelectric conversion layer D is provided along the outer surface of the electron transport layer 40 and the inner surface of the pore 41. It is therefore possible to transfer the electrons produced in the photoelectric conversion layer D to the electron transport layer 40 efficiently.

Referring to Fig. 4, the photoelectric conversion layer D includes a second film 2 bonded to the electron transport layer 40, a third film 3, and a first film 4 placed between the second film 2 and the third film 3.

The second film 2 includes a plurality of first structure units each of which is bonded to the electron transport layer 40 with a bonding group 5 therebetween. The bonding group 5 serves as an anchor to the electron transport layer 40, thereby bonding the second film 2 (first structure units) to the electron transport layer 40 strongly.

Examples of the bonding group 5 are not particularly limited as long as they can be bonded to the electron transport layer 40, and preferably a thiol group, a sulfonate group, a carboxyl group, a tertiary amino group, a phosphoric group, or a cyano group, for example. More preferably, the bonding group 5 is at least one of a thiol group, a sulfonate group, a carboxyl group, and a tertiary amino group. The bonding group 5 is bonded to a metal or semiconductor material more strongly, thereby bonding the second film 2 to the electron transport layer 40 more strongly.

It is also noted that the bonding group 5 may be what is electrostatically bonded or hydrogen-bonded to the electron transport layer 40, for example.

If is the electron transport layer 40 is made of an oxide semiconductor material, it is particularly preferable that the bonding group 5 be at least one of a sulfonate group, a carboxyl group, and a tertiary amino group among the above-mentioned types of the bonding group 5. Accordingly, the bonding group 5 can be bonded to the electron transport layer 40 more strongly. In other words, the photoelectric conversion layer D and the electron transport layer 40 can be spatially close to each other with the bonding group 5 therebetween, making electron transfer between the photoelectric conversion layer D and the electron transport layer 40 efficiently. The electrons are further transferred from the electron transport layer 40 to the first electrode 30.

If is the electron transport layer 40 is made of a metal material, such as gold, silver, and platinum, it is particularly preferable that the bonding group 5 be a thiol group. Accordingly, the bonding group 5 can be bonded to the electron transport layer 40 more strongly.

When using this bonding group 5, it is possible to omit the electron transport layer 40 and make the first electrode 30 of a noble metal material to make the multilayer structure 1 and the solar cell 10. Accordingly, it is possible to provide the solar cell 10 with a simplified structure by a simplified manufacturing process. In this case, the first electrode (electrode) 30 serves as a base.

Furthermore, the first structure units are bonded to a polymerization group and a hydrophobic group 7a in the present embodiment.

The polymerization group is polymerized in a manufacturing process of the solar cell 10, which will be described later, to become the first film 4. Accordingly, the first film 4 chemically bonded to the first structure units can be easily provided.

It is preferable that the polymerization group be an unsaturated hydrocarbon group capable of being radically polymerized.

Among types of such unsaturated hydrocarbon group capable of being radically polymerized, one of a vinyl group, an allyl group, an acryloyl group, a methacryloyl group, a propenyl group, a vinylidene group, and a vinylene group is preferably used. Among them, an acryloyl group and a methacryloyl group are more preferably used.

As the hydrophobic group 7a, at least one of an alkyl group and an aryl group is preferably used. The hydrophobic group 7a may contain a carbon-fluorine bond. Accordingly, the hydrophobic group 7a may have higher hydrophobicity.

Moreover, the first structure units may include a structure having various types of substituents. Examples of the substituents may include, but not be limited to, a saturated chain hydrocarbon group and a saturated ring hydrocarbon group.

A specific example of a compound (first compound) including the first structure unit, the bonding group 5, the polymerization group, the hydrophobic group 7a, and various types of substituents is represented by the following formula (2).

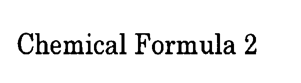

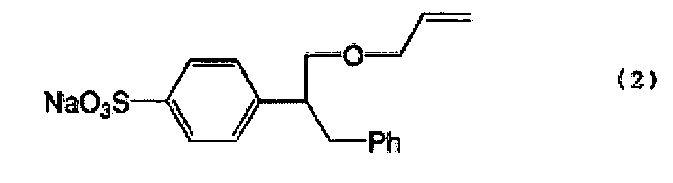

The third film 3 includes a plurality of second structure units. The film is provided in a way that the first film 4, which will be described later, is provided between the film and the second film 2.

In the present embodiment, the second structure units produce electrons upon receiving an optical stimulus from light as described earlier. The second structure units thus perform photoelectric conversion to convert optical energy into electrical energy.

Here, the optical stimulus may be application of excitation light, for example.

While it is assumed that the stimulus applied by energy from light is given in the present embodiment, an energy source is not particularly limited and it may give a stimulus applied by energy from electricity, heat, radiation, elementary particle beams, or the like.

The electrons produced by the second structure units move, via the first film 4, which will be described later, and the second film 2, sequentially to the electron transport layer 40 and the first electrode 30 to be a current. Thus in the multilayer structure 1 according to the present embodiment, the electrons move in the direction from the third film 3 side to the electron transport layer (base) 40 side or the reverse direction.

The second structure units include a pigment 8.

Examples of the pigment 8 may include: RuL₂(SCN)₂, RuL₂Cl₂, RuL₂CN₂, Ruthenium 535 bis-TBA (made by Solaronics), [RuL₂(NCS₂)]₂H₂O and other ruthenium complex, iron complex, osmium complex, copper complex, platinum complex and other metal complex pigments; cyan, xanthene, azo, hibiscus, blackberry, raspberry, pomegranate juice, chlorophyll, and other pigments. They may be used singly or in combination.

Among them, the metal complexes are preferably used as the pigment 8. This is because the metal complexes have relatively wide ranges of wavelengths of light that can be absorbed and also have excellent photosensitization properties.

Furthermore, the ruthenium or iron complex is more preferably used as the pigment 8. These complexes have particularly excellent photosensitization properties and relatively high chemical stability.

Furthermore, the second structure units are bonded to a polymerization group and a hydrophobic group 7b in the present embodiment.

The polymerization group is polymerized in a manufacturing process of the solar cell 10, which will be described later, to become the first film 4. Accordingly, the first film 4 chemically bonded to the first structure units can be easily provided.

The same can be said for this polymerization group and the hydrophobic group 7b as the above-described polymerization group and the hydrophobic group 7a bonded to the first structure unit.

Furthermore, the second structure units have electric charges in the present embodiment. Accordingly, if the hole transport layer 50 in the solar cell 10 is replaced with an electrolyte with high polarity, it is possible to enhance the electron transfer efficiency of the photoelectric conversion layer D to the electrolyte. Consequently, a portion in contact with the photoelectric conversion layer D, that is, a portion receiving holes from the photoelectric conversion layer D, is not necessarily limited to either the hole transport layer 50 or the electrolyte. It is possible to provide the both with stable photoelectric conversion efficiency.

As will be described in greater detail later, since the second structure units have electric charges, a structure etc. having an opposite polarity to that of the charges can be oriented to the side of the third film that is remote from the second film by means of electrical interaction. Specifically, the structure can be oriented toward the second structure units having the charges in a way that the structure having an opposite polarity to that of the charges forms a micelle. It is therefore possible to efficiently cover the photoelectric conversion layer D with the structure and provide the photoelectric conversion layer D with various properties the structure has.

Moreover, the second structure units may also include various types of substituents. Examples of the substituents may preferably include, but not be limited to, a saturated chain hydrocarbon group and a saturated ring hydrocarbon group.

Specific examples of a compound (second compound) including the second structure unit, the polymerization group, the hydrophobic group 7b, and various types of substituents are represented by the following formulae (3) to (7).

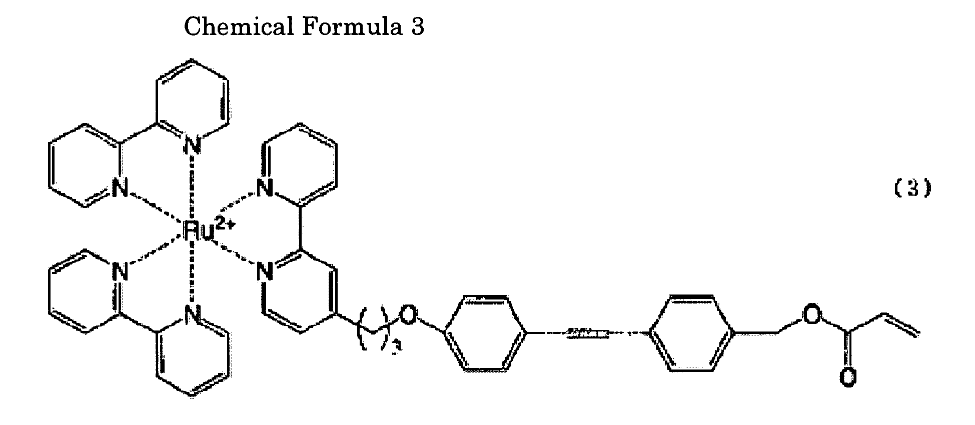

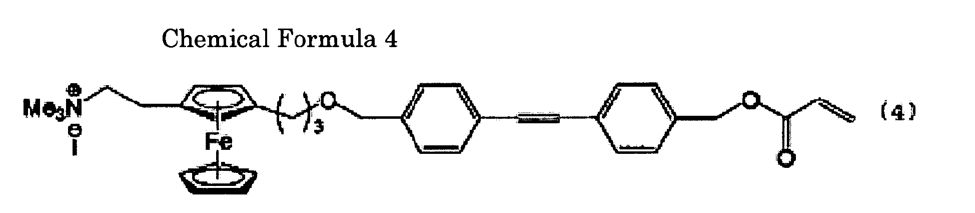

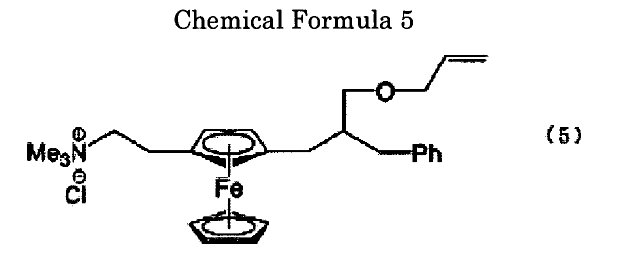

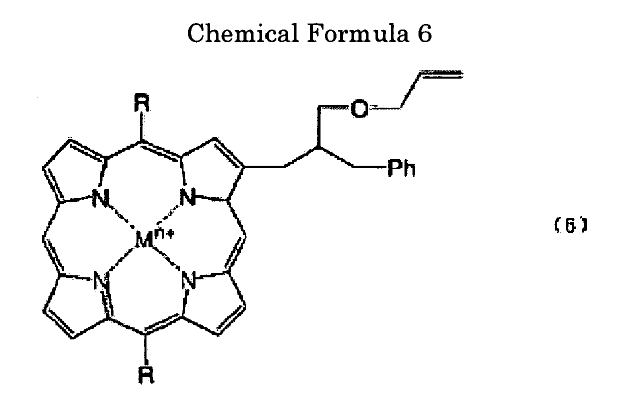

(In this formula, M represents zinc, copper or nickel, n is 2 or 3, and R represents an alkyl group.)

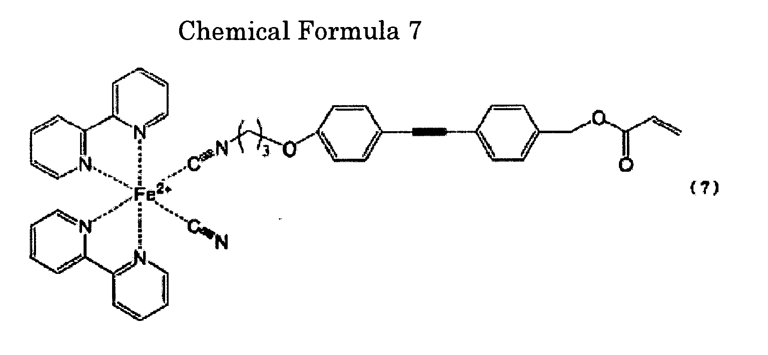

Among these compounds, the compound represented by the formula (3) can be composed by a synthetic pathway as shown by the formula (8) below, for example.

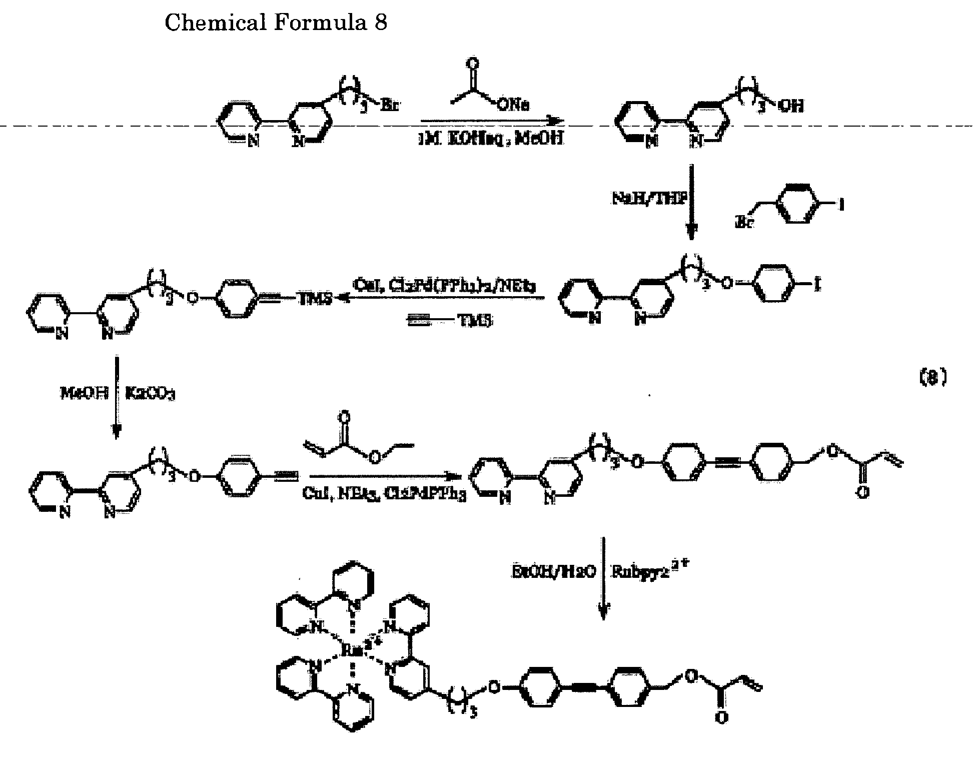

The compound represented by the formula (4) can be composed by a synthetic pathway as shown by the formula (9) below, for example.

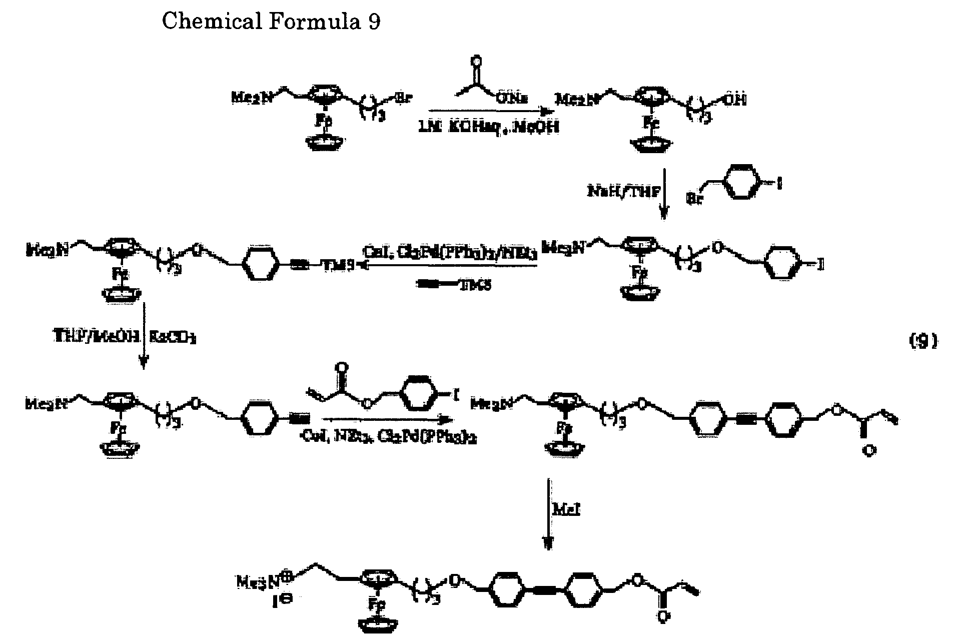

The first film 4 is provided between the second film 2 and the third film 3 by polymerizing at least one of the following: a polymerization group bonded to one of the plurality of first structure units, and a polymerization group bonded to one of the plurality of second structure units. Accordingly, it is chemically bonded to at least one first structure unit out of the plurality of first structure units or at least one second structure unit out of the plurality of second structure units. It is therefore possible to bond the first film 4 to the second film 2 (each first structure unit) or the third film 3 (each second structure unit) more strongly.

Here, "being chemically bonded" refers to a bonding based on a covalent, ion, or hydrogen bonding, for example. Among them, the bonding is preferably a covalent bonding, which makes the bonding more strong.

According to the present embodiment, while the bonding group 5 of the first compound is bonded to the electron transport layer (base) 40 to array the polymerization group and the hydrophobic group 7a in the first compound toward a direction opposite to the electron transport layer 40 and array the polymerization group and the hydrophobic group 7b in the second compound toward the first compound side, the first film 4 is provided by polymerizing the polymerization group in the first compound and the polymerization group in the second compound. This means that the first film 4 is made of a polymer.

The first film 4 has various functions. For example, it is preferable that the film have a function to restrict reverse electron transfer, which means electrons that have moved from the third film 3 side to the second film 2 side from moving back from the second film 2 side to the third film 3 side.

The above-mentioned function is achieved by spatially separating the second film 2 (each first structure unit) and the third film 3 (each second structure unit) by the polymer of the first film 4. Specifically, the first film 4 can lower the speed of electrons moving in a direction reverse (reverse electron transfer) to a direction in which they usually move, that is, the speed of electrons moving from the second film 2 side to the third film 3 side. Consequently, it becomes difficult for the electrons to move in the reverse direction, and it is thus possible to prolong the life of a charge separation state and enhance the photoelectric conversion efficiency of the solar cell 10. It is also noted that the direction in which electrons move may be reverse. In other words, the first film 4 can also restrict electrons that have moved from the second film 2 side to the third film 3 side from moving from the third film 3 side to the second film 2 side.

In addition to the above function, it also has a function to restrict the transmission of any chemical species, such as oxygen and hydrogen, that capture radical ions and other intermediates produced in response to energy applied. When this function is important, it can be enhanced by using a fine polymer film, for example, as the first film 4.

It is noted that the first film 4 may be chemically bonded to at least either the first structure units or the second structure units, and it does not have to be chemically bonded to the both.

The first film 4 can take in the hydrophobic group 7a to which the first structure units are bonded and the hydrophobic group 7b to which the second structure units are bonded as shown in Fig. 4 during the polymerization. Accordingly, the first film 4 becomes a film with higher hydrophobicity. Therefore, for example, it is possible to more surely prevent the second film 2 and the electron transport layer 40 from aging deterioration due to the second film 2 coming in contact with moisture or other chemical species during a process to manufacture the solar cell 10 or when the hole transport layer 50 is replaced with an electrolyte.

If the polymer of the first film 4 without the hydrophobic group 7a of the first structure units and the hydrophobic group 7b of the second structure units has sufficient hydrophobicity, the polymer may include only one of the hydrophobic group 7a and the hydrophobic group 7b, or neither of them.

The hole transport layer 50 is provided in contact with the photoelectric conversion layer D. The hole transport layer 50 has a function to capture holes produced in the photoelectric conversion layer D and transport them.

The hole transport layer 50 has a layer structure as the whole. Referring to Fig. 2, part of the layer on the electron transport layer 40 side fills the pore 41 in the electron transport layer 40. It is therefore possible to increase a contact area between the photoelectric conversion layer D and the hole transport layer 50, and thus to transport holes produced in the photoelectric conversion layer D to the hole transport layer 50 more efficiently. Accordingly, the power generation efficiency of the solar cell 10 can be further enhanced.

Examples of materials of the hole transport layer 50 may include: polyarylamine, fluorene-arylamine copolymer, fluorene-bithiophene copolymer, poly(N-vinylcarbazole), polyvinylpyrene, polyvinylanthracene, polythiophene, polyalkylthiophene, polyhexylthiophene, poly(p-phenylenevinylene), polythienylenevinylene, pyrene formaldehyde resin, ethylcarbazole formaldehyde resin, their derivatives and other polymer materials; organic polymers such as dendrimer having a thiophene skeleton; naphthalene, anthracene, tetracene, pentacene, hexacene, phthalocyanine, perylene, hydrazone, triphenylmethane, diphenylmethane, stilbene, arylvinyl, pyrazoline, triphenylamine, triarylamine, oligothiophene, phthalocyanine, their derivatives and other organic low-molecular-weight materials; I₂, LiI, NaI, KI, CsI, CuI, AgI, CaI₂, and other metal iodides; Br₂, LiBr, NaBr, KBr, CsBr, AgBr, CaBr₂ and other metal bromides; tetraalkylammonium iodide, pyridinium iodide, imidazolium iodide, and other quaternary ammonium iodine salts; tetraalkylammonium bromide, pyridinium bromide, and other quaternary ammonium bromide salts; ferrocyanide salt ― ferricyanide salt, ferrocene-ferricinium ion, and other metal complexes; NiO, CoO, Bi₂O₃, MoO₂, Cr₂O₃, and other semiconductor oxides; sodium polysulfide, alkylthiol-alkyldisulfide, and other sulfur compounds. They may be used singly or in combination.

To make the hole transport layer 50 liquid, examples of a solvent to solve the above materials may include: ethylene carbonate, propylene carbonate, and other carbonate compounds; 3-methyl-2-oxazolidinone and other heterocyclic compounds; dioxane, diethyl ether, and other ether compounds; methanol, ethanol, and other alcohols; ethylene glycol, propylene glycol, polyethylene glycol, polypropylene glycol, glycerin, and other polyhydric alcohols; acetonitrile, glutarodinitrile, methoxyacetonitrile, propionitrile, benzonitrile, and other nitrile compounds; distilled water, ultrapure water, ion-exchange water, reverse osmosis (RO) water, and other waters. They may be used singly or in combination.

The content of the above-mentioned materials in the electrolysis is preferably about 0.1 to 10.0 mol/L, and more preferably about 0.2 to 4.0 mol/L.

Moreover, the polymer can be used as a mix with other polymer materials. For example, poly(3,4-ethylenedioxythiophene/styrenesulfonate) (PEDOT/PSS) can be used as a mix containing polythiophene.

The average thickness of the hole transport layer 50 (except for its part filling the pore 41) is not particularly limited, but preferably about 1 to 500 µm, more preferably about 10 to 300 µm, and further preferably about 10 to 30 µm.

Provided on the hole transport layer 50 (on its side remote from the first electrode 30) is the second electrode 60 placed face to face with the first electrode 30.

Examples of materials of the second electrode 60 may include: metal materials of aluminum, nickel, cobalt, platinum, silver, gold, copper, molybdenum, titanium and tantalum or their alloys; and carbon materials such as graphite. They may be used singly or in combination.

The average thickness of the second electrode 60 is not limited and set appropriately depending on its materials, applications of the solar cell 10, and so forth.

When light is incident on the solar cell 10, electrons (e⁻) move primarily from the photoelectric conversion layer D to the electron transport layer 40, thereby creating a potential difference (photovoltaic power) between the first electrode 30 and the second electrode 60 and causing an electric current (photoexcited current) to flow in the external circuit 70.

It is preferable that the solar cell 10 have a property in which its resistance becomes 100 Ω/cm² or more (1 kΩ/cm² or more, preferably) when a voltage of 0.5 V is applied with the first electrode 30 being positive and the second electrode 60 being negative. The solar cell 10 with this property can desirably prevent or restrict a short circuit (leak) due to contact between the first electrode 30 and the hole transport layer 50, for example, thereby further enhancing its power generation efficiency (photoelectric conversion efficiency).

The solar cell 10 can be manufactured as follows, for example.

(1) A multilayer structure in which the substrate 20, the first electrode 30, and the electron transport layer 40 are deposited is prepared.

(1-1) The substrate 20 is prepared. The first electrode 30 is provided on the substrate 20.

The first electrode 30 can be provided by vapor deposition, sputtering, or printing, for example.

(1-2) On the first electrode 30, the electron transport layer 40 is provided.

The electron transport layer 40 can be provided by supplying a dispersion liquid (suspension) containing a material to form the electron transport layer, which is the above-described particles and/or tubular bodies, on the first electrode 30, and burning the material after the liquid is removed, for example.

The content of the material to form the electron transport layer in the dispersion liquid is preferably, but not limited to, about 0.1 to 10.0 wt%, and more preferably about 0.5 to 5.0 wt%.

Examples of the dispersion medium may include: distilled water, ultrapure water, ion-exchange water, RO water, and other waters, methanol, ethanol, isopropyl alcohol, acetonitrile, ethyl acetate, ether, methylene chloride, and N-methyl-2-pyrrolidone (NMP).

Moreover, it is also possible to add a stabilizer such as nitric acid; a surface modification reagent of titanium dioxide such as acetic acid and acetylacetone; a cationic, anionic, cationic-anionic, or nonionic surfactant; a binder such as polyethylene glycol; a plasticizer; and an antioxidant to the dispersion liquid as required.

Examples of methods to supply the dispersion liquid containing a material to form the electron transport layer may include: dipping, dropping, doctor blading, spin coating, blushing, spray coating, roll coating, and other application methods. These application methods do not require any large-scale devices and can provide the electron transport layer 40 to a desired thickness relatively easily.

The burning is performed at about 250 to 500 degrees Celsius for half an hour to three hours, for example.

(2) The photoelectric conversion layer D is provided to come in contact with the electron transport layer 40.

(2-1) The second film 2 is provided to come in contact with the electron transport layer 40.

The second film 2 can be provided by making a liquid containing the first structure units come in contact with the electron transport layer 40, for example.

Consequently, the bonding group 5 bonded to the first structure units is bonded to the electron transport layer 40 strongly. It is therefore possible to orient the first structure units on the surface of the electron transport layer 40 to form a micelle, and thus to provide the second film 2 as shown in Fig. 5A easily and surely.

Examples of methods to make the liquid containing the first structure units come in contact with the electron transport layer 40 may include: dipping the electron transport layer 40 in the liquid containing the first structure units (dipping method), applying the liquid containing the first structure units to the electron transport layer 40 (application method), and providing to the electron transport layer 40 with the liquid containing the first structure units like a shower.

Examples of a solvent (or a dispersion medium) to prepare the liquid containing the first structure units may include: various types of waters, methanol, ethanol, isopropyl alcohol, acetonitrile, ethyl acetate, ether, methylene chloride, and N-methyl-2-pyrrolidone (NMP). They may be used singly or in combination.

If the dipping method is used, the liquid containing the first structure units may be irradiated with ultrasonic waves for a predetermined period of time as required while the electron transport layer 40 is dipped therein. Accordingly, it is possible to extremely highly control the alignment of the first structure units stuck and oriented to the electron transport layer 40. Moreover, ultrasonic waves can make the first structure units fill the pore 41 in the electron transport layer 40, thereby achieving more precise orientation.

(2-2) On the side of the second film 2 remote from the electron transport layer 40, the third film 3 is provided.

The third film 3 can be provided by making a liquid containing the second structure units come in contact with the second film 2, for example.

Accordingly, a polymerization group 6b and the hydrophobic group 7b bonded to each second structure units are disposed to face a polymerization group 6a and the hydrophobic group 7a bonded to the first structure unit. It is therefore possible to orient the second structure units on the surface of the second film 2 to form a micelle, and thus to provide the third film 3 as shown in Fig. 5B.

A method similar to the above-described process (2-1) can be used to make the liquid containing the second structure units come in contact with the second film 2.

Also, a solvent (or a dispersion medium) similar to one used in the above-described process (2-1) can be used to prepare the liquid containing the second structure units.

(2-3) Between the second film 2 and the third film 3, the first film 4 is provided to form the photoelectric conversion layer D.

The first film 4 can be provided by making a liquid containing a polymerization initiator come in contact with the second film 2 and the third film 3, for example.

Consequently, a polymerization reaction occurs at least one of the following to make a polymer: between the polymerization group 6a bonded to the first structure units and the polymerization group 6b bonded to the second structure units; between each polymerization group 6a bonded to the first structure units; and between each polymerization group 6b bonded to the second structure units. Thus the first film 4 can be provided as shown in Fig. 5C.

Here, it is possible to activate the polymerization initiator by increasing the temperature of the liquid containing the polymerization initiator to a predetermined level (at which the polymerization initiator becomes activated) as required. It is therefore possible to desirably perform polymerization in the liquid containing the polymerization initiator.

The polymerization initiator is preferably soluble in water. Examples of the initiator may include: potassium persulfate, ammonium persulfate, sodium persulfate, 2,2-azobis-(2-metylpropionamidine) dihydrochloride, and 4,4-azobis-(4-cyanovaleric acid).

The above-mentioned polymerization reaction preferably occurs in a reactor having an ultrasonic generator, an agitator, a reflux cooler, a dropping funnel, and a temperature regulator.

In the polymerization reaction, the polymerization initiator is cleaved, by increasing the temperature of the initiator added into the reaction system (the liquid containing the initiator), to generate initiator radicals. The initiator radicals attack each polymerization group 6a, 6b, which starts the polymerization reaction.

The activation of the polymerization initiator in the reaction system is preferably achieved by increasing the temperature of the liquid including the initiator to the predetermined polymerization temperature as mentioned above. The polymerization temperature depends upon the composition of the polymerization initiator, and is preferably within a range from 60 to 90 degrees Celsius, for example. The time for polymerization is preferably from 3 to 10 hours, for example.

(2-4) As required, the substrate 20 provided with the photoelectric conversion layer D is dried.

Drying can be performed by various methods including freeze-drying, through-flow drying, surface drying, fluidized drying, flash drying, spray drying, vacuum drying, infrared drying, high-frequency drying, ultrasonic drying, and pulverization drying. Among these methods, freeze-drying is preferably used here.

Since the freeze-drying method dries a solvent by sublimating it (solid to gas), it is possible to perform drying without making almost any influence on the shape and functions of the multilayer structure 1 of the photoelectric conversion layer D.

The drying method will now be described in greater detail.

First, the substrate 20 taken out from the liquid in the process (2-3) is cooled and frozen. Accordingly, the solvent contained in the photoelectric conversion layer D becomes solidified.

The cooling temperature is not particularly limited as long as the solvent is frozen, and preferably about -100 to -20 degrees Celsius and more preferably about -80 to -40 degrees Celsius. If the cooling temperature surpasses such a range, the solvent may not be fully solidified, on one hand. On the other, even if the cooling temperature is below the range, the solidification of the solvent does not advance to a greater degree.

Next, the pressure around the substrate 20 that has been frozen is reduced. It is therefore possible to lower the boiling point of the solvent and sublimate the solvent.

The reduced pressure depends upon the composition of the solvent, and is preferably about 100 Pa or less and more preferably about 10 Pa or less. If the reduced pressure is within such a range, the solvent can be sublimated more surely.

While the pressure around the substrate 20 increases along with the sublimation, the pressure is preferably maintained at a fixed level during the freeze-drying process by continuous air evacuation with an evacuation pump, for example. It is therefore possible to restrict a pressure rise and prevent an effect of the sublimation of the solvent from shrinking.

The substrate 20 provided with the photoelectric conversion layer D can be thus freeze-dried.

(3) The hole transport layer 50 is provided to come in contact with the photoelectric conversion layer D.

The hole transport layer 50 is provided by liquid-phase deposition, for example.

Liquid-phase deposition do not require any large-scale devices and can provide the hole transport layer 50 easily and economically.

First, a liquid material (solution or dispersion liquid) containing a material to form the hole transport layer is prepared.

The solvent or dispersion medium to prepare the liquid material may be inorganic or organic solvents or mixed solvents including them. Examples of the inorganic solvents may include: nitric acid, sulfuric acid, ammonia, hydrogen peroxide, water, carbon disulfide, carbon tetrachloride, and ethylene carbonate. Examples of the organic solvents may include: methyl ethyl ketone (MEK), acetone, diethyl ketone, methyl isobutyl ketone (MIBK), methyl isopropyl ketone (MIPK), cyclohexanone, and other ketone solvents; methanol, ethanol, isopropanol, ethylene glycol, diethylene glycol (DEG), glycerine, and other alcohol solvents; diethyl ether, diisopropyl ether, 1,2-dimetoxyethane (DME), 1,4-dioxane, tetrahydrofuran (THF), tetrahydropyran (THP), anisole, diethylene glycol dimethyl ether (diglyme), diethylene glycol ethyl ether (carbitol), and other ether solvents; methyl cellosolve, ethyl cellosolve, phenyl cellosolve, and other cellosolve solvents; hexane, pentane, heptane, cyclohexane, and other aliphatic hydrocarbon solvents; toluene, xylene, benzene, and other aromatic hydrocarbon solvents; pyridine, pyrazine, furan, pyrrole, thiophene, methylpyrrolidone, and other heteroaromatic compound solvents; N,N-dimethylformamide (DMF), N,N-dimethylacetamide (DMA), and other amide solvents; chlorobenzene, dichloromethane, chloroform, 1,2-dichloroethane, and other halogenated compound solvents; ethyl acetate, methyl acetate, ethyl formate, and other ester solvents; dimethylsulfoxide (DMSO), sulfolane, and other sulfur compound solvents; acetonitrile, propionitrile, acrylonitrile, and other nitrile solvents; and formic acid, acetic acid, trichloroacetic acid, trifluoroacetic acid, and other organic acid solvents.

Among them, acetonitrile is preferably used as the solvent. In this case, if CuI is used as the material to form the hole transport layer, a cyanoethylated compound such as cyanoresin may be added as a binder of CuI into the acetonitrile solution of CuI. In this case, the mix ratio by weight of CuI and the cyanoethylated compound is preferably about 95.5:0.5 to 95:5, for example.

If a polymer is used as the material to form the hole transport layer, a nonpolar solvent is preferably used among others. For example, xylene, toluene, cyclohexylbenzene, dihydrobenzofuran, trimethylbenzene, tetramethylbenzene, and other aromatic hydrocarbon solvents; pyridine, pyrazine, furan, pyrrole, thiophene, methylpyrrolidone, and other heteroaromatic compound solvents; hexane, pentane, heptane, cyclohexane, and other aliphatic hydrocarbon solvents can be used singly or in combination.

Then, the liquid material is supplied onto the photoelectric conversion layer D to form a film (thin or thick film).

Among the above-described various application methods, inkjet printing (droplet discharge) in particular is preferably used to supply the liquid material (liquid-phase deposition). Inkjet printing can provide a liquid film to high accuracy without wasting the liquid material.

Then, the solvent or dispersion medium is removed from the liquid film, which completes the hole transport film 50.

Examples of the method to remove the solvent or dispersion medium may include leaving them under atmospheric or reduced pressure, heating, or inert-gas blowing, for example.

The heating temperature is preferably from 50 to 150 degrees Celsius. If heat treatment follows the forming of the film, drying of the film may precede the heat treatment. The above-mentioned process may be repeated multiple times.

Specifically, the substrate 20 provided with the first electrode 30, the electron transport layer 40, and the photoelectric conversion layer D is placed on a hot plate that has been heated to about 80 degrees Celsius. The material to form the hole transport layer is dropped onto the upper surface of the photoelectric conversion layer D and dried. This process is repeated multiple times to form a multilayer, so that the hole transport layer 50 can be provided to the above-mentioned average thickness.

The material to form the hole transport layer preferably includes a substance to improve hole transport efficiency. If the material to form the hole transport layer includes such a substance, charge mobility in the hole transport layer 50 increases because of an increase in ion conductivity.

Examples of the substance may include, but not be particularly limited to, ammonium halides and other halides. In particular, tetrapropylammonium iodide (TPAI) and other ammonium halides are preferably used. By using tetrapropylammonium iodide, the charge mobility of the substance with ion conductivity properties can further increase.

(4) The second electrode 60 is provided on the hole transport layer 50 in the same manner as the process (1-1).

Thus the method for manufacturing the solar cell 10 can provide each layer at relatively low temperatures. Therefore, the method is suitable for manufacturing the solar cell 10 with a flexible substrate, i.e., the substrate 20 is primarily made of a resin material, in particular.

### Second Embodiment

A second embodiment of a multilayer structure and a photoelectric conversion element according to the invention will now be described.

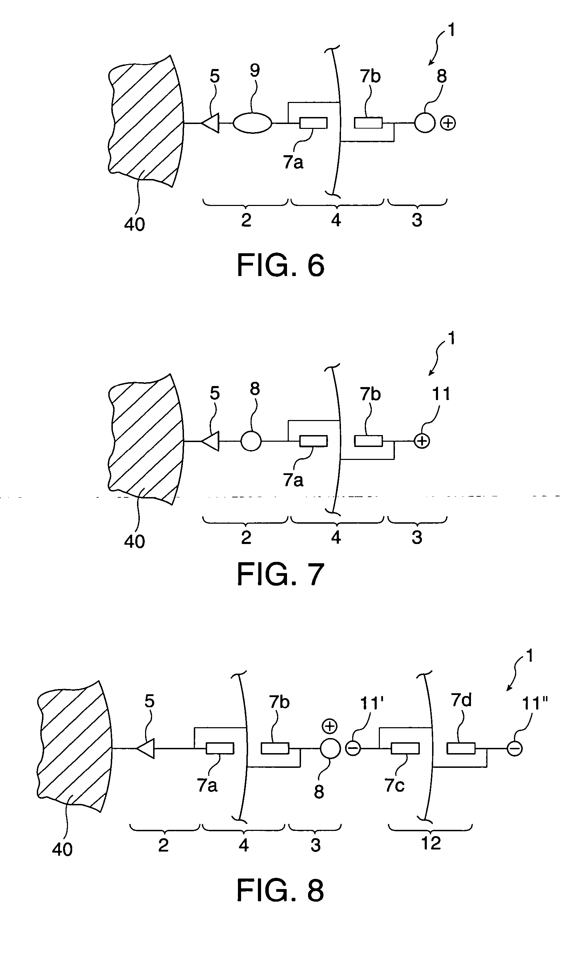

Fig. 6 is a schematic showing the second embodiment of the multilayer structure according to the invention.

The following description of the second embodiment of the multilayer structure and the photoelectric conversion element according to the invention focuses primarily on differences from the first embodiment, and similar points will be omitted.

The second embodiment involves the structures similar to the multilayer structure 1 and the solar cell 10 of the first embodiment, except that the second structure unit in the second film 2 include an electron acceptor 9 that accepts electrons as shown in Fig. 6 as well as the elements of the first embodiment.

With this multilayer structure 1, electrons produced in the pigment 8 included in the third film 3 first move to the electron acceptor 9, and then to the electron transport layer 40. Since electrons move in this way, they can move at higher speed. Since it becomes extremely difficult for the electrons to move in the reverse direction from the electron transport layer 40 to the third film 3 (reverse electron transfer), it is possible to prolong the life of a charge separation state and thus enhance the photoelectric conversion efficiency of the solar cell 10.

While the electron acceptor 9 may have any structure as long as it has an electron-accepting property, it preferably has a structure represented by the following formula (1).

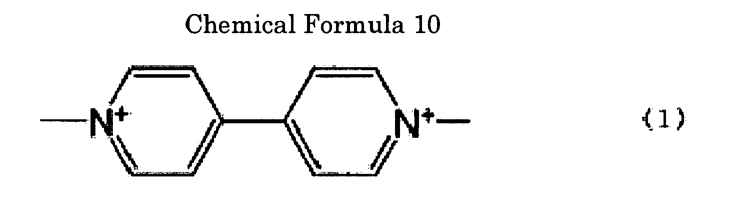

Since the structure represented by the above formula (1) has a particularly excellent electron-accepting property, electrons can move from the pigment 8 included in the third film 3 to the electron transport layer 40 at particularly high speed. It is therefore possible to restrict the reverse electron transfer and further enhance the photoelectric conversion efficiency of the solar cell 10.

A specific example of a compound including the second structure unit having the electron acceptor 9 is represented by the following formula (10).

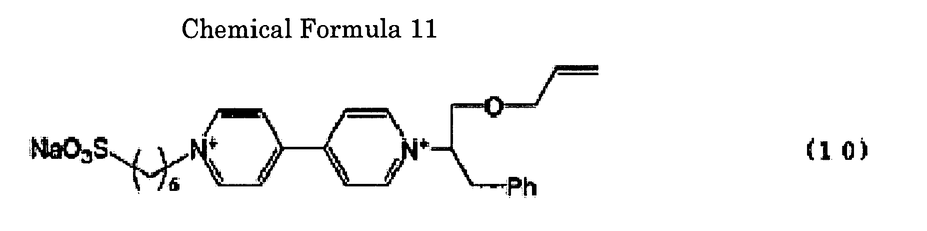

### Third Embodiment

A third embodiment of a multilayer structure and a photoelectric conversion element according to the invention will now be described.

Fig. 7 is a schematic showing the third embodiment of the multilayer structure according to the invention.

The following description of the third embodiment of the multilayer structure and the photoelectric conversion element according to the invention focuses primarily on differences from the first and second embodiments, and similar points will be omitted.

The third embodiment is similar to the first embodiment, except that the second film 2 is a film that produces electrons and holes upon receiving an optical stimulus from light and the third film 3 is a film that includes a plurality of polar groups 11.

Specifically, the second film 2 includes the first structure unit and is bonded to the electron transport layer 40 with the bonding group 5 bonded to the first structure unit therebetween.

The bonding group 5 can be similar to one in the first embodiment.

In the present embodiment, as described above, the first structure unit produces electrons and holes upon receiving an optical stimulus from light. The first structure unit thus performs photoelectric conversion to convert optical energy into electrical energy.

The electrons produced by the first structure unit move sequentially to the electron transport layer 40 and the first electrode 30 to be a current.

The first structure unit includes the pigment 8.

The pigment 8 can be similar to one in the first embodiment.

A specific example of a compound including the first structure unit is represented by the following formula (11).

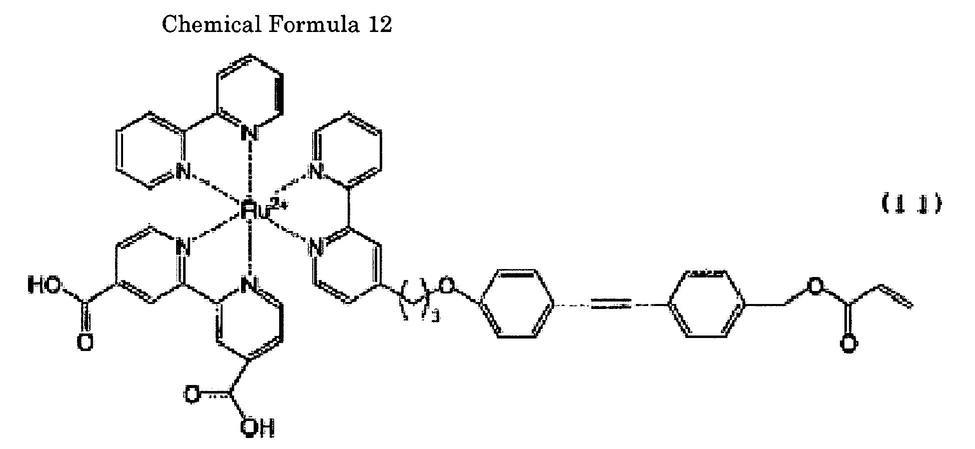

The third film 3 includes-the second structure unit. Between this film and the second film 2, the first film 4, which will be described later, is provided.

According to the present embodiment, the second structure unit is bonded to the plurality of polar groups 11. Accordingly, if the hole transport layer 50 in the solar cell 10 is replaced with an electrolyte, it is possible to enhance the carrier transfer efficiency of the photoelectric conversion layer D to the electrolyte. Consequently, a portion in contact with the photoelectric conversion layer D is not necessarily limited to either the hole transport layer 50 or the electrolyte. It is possible to provide the both with stable photoelectric conversion efficiency.

Examples of the polar groups 11 may include: a primary amine cationic group, a secondary amine cationic group, a tertiary amine cationic group, a quaternary ammonium cationic group, and other cationic groups; and a sulfonate anionic group, a sulfinate anionic group, a carboxylic acid anionic group, and other anionic groups.

A specific example of a compound including the second structure unit bonded to the polar groups 11 is represented by the above-mentioned formula (2).

### Fourth Embodiment

A fourth embodiment of a multilayer structure and a photoelectric conversion element according to the invention will now be described.

Fig. 8 is a schematic showing the fourth embodiment of the multilayer structure according to the invention.

The following description of the fourth embodiment of the multilayer structure and the photoelectric conversion element according to the invention focuses primarily on differences from the first to third embodiments, and similar points will be omitted.

The fourth embodiment is similar to the first embodiment, except that a protection film (fourth film) 12 is provided on the side of the third film 3 remote from the electron transport layer 40. In other words, the third film 3 (the plurality of second structure units) is disposed between the protection film 12 and the first film 4.

The protection film 12 is preferably made of a polymer. Accordingly, the protection film 12 can be a fine film.

According to the present embodiment, the protection film (polymer film) 12 is provided by polymerizing a polymerization group bonded to one of a plurality of third structure units and a polymerization group bonded to one of a plurality of fourth structure units. Accordingly, the protection film 12 can be bonded to the third structure units and the fourth structure units strongly.

It is noted that the protection film 12 may be chemically bonded to at least either the third structure units or the fourth structure units, and it does not have to be chemically bonded to the both.

According to the present embodiment, the protection film 12 includes a hydrophobic group 7c included in the third structure units and a hydrophobic group 7d included in the fourth structure units as shown in Fig. 8. Accordingly, the protection film 12 can be a film with hydrophobicity. Accordingly, for example, if the hole transport layer 50 is replaced with an electrolyte, it is possible to prevent the second film 2, the third film 3, the first film 4, and the electron transport layer 40 from coming in contact with moisture more surely. It is therefore possible to restrict aging deterioration of the second film 2, the third film 3, the first film 4, and the electron transport layer 40 and to prolong the life of the solar cell 10.

Bonded to the protection film 12 on its side provided with the third film 3 are a plurality of polar groups 11' having an opposite polarity to that of the electric charges the second structure units in the third film 3 have. It is therefore possible to extremely highly control the alignment of the third structure units in a way that the polar groups 11' of the third structure units are placed face to face with the electric charges while manufacturing the protection film 12 as described later. Consequently, the protection film 12 made of a finer polymer can be provided and functions of the protection film 12 can be enhanced.

Bonded to the protection film 12 on its side remote from the third film 3 are a plurality of polar groups 11" in the present embodiment. In other words, the protection film 12 is disposed between the plurality of polar groups 11" and the third film 3 (the plurality of second structure units). Accordingly, if the hole transport layer 50 in the solar cell 10 is replaced with an electrolyte with high polarity, it is possible to enhance the electron transfer efficiency of the photoelectric conversion layer D to the electrolyte. Consequently, a portion in contact with the photoelectric conversion layer D, that is, a portion receiving holes from the photoelectric conversion layer D, is not necessarily limited to either the hole transport layer 50 or the electrolyte. It is possible to provide the both with stable photoelectric conversion efficiency.

It is noted that the polarity of the polar groups 11" is not limited.

The polar groups 11', 11" can be similar to one in the first embodiment.

The third structure units and the fourth structure units may have the same structure. A specific example of a compound including them is represented by the above-mentioned formula (2).

The compound including the third structure units and the fourth structure units may be a cationic or anionic polymerization surfactant.

Among them, the cationic polymerization surfactant is a surfactant having a cationic group, a polymerization group, and a hydrophobic group.

Examples of the cationic group included in the cationic polymerization surfactant may include: a primary amine cationic group, a secondary amine cationic group, a tertiary amine cationic group, a quaternary ammonium cationic group, a quaternary phosphonium cationic group, a sulfonium cationic group, and a pyridinium cationic group.

Among them, the cationic group is preferably one of the following: a primary amine cationic group, a secondary amine cationic group, a tertiary amine cationic group, and a quaternary ammonium cationic group.

As the hydrophobic group included in the cationic polymerization surfactant, at least one of an alkyl group and an aryl group is preferably used.

As the polymerization group included in the cationic polymerization surfactant, an unsaturated hydrocarbon group capable of being radically polymerized is preferably used. Accordingly, it is possible to convert the polymerization group to a polymer more easily.

Among types of such unsaturated hydrocarbon group capable of being radically polymerized, one of a vinyl group, an allyl group, an acryloyl oil, a methacryloyl group, a propenyl group, a vinylidene group, and a vinylene group is preferably used. Among them, an acryloyl group and a methacryloyl group are more preferably used.

Cationic allyl acid derivatives described in JP-A-4-65824 is an example of the cationic polymerization surfactant. Examples of the cationic polymerization surfactant may include: dimethylaminoethyl methacrylate methyl chloride, dimethylaminoethyl methacrylate benzyl chloride, methacryloyloxy ethyl trimethylammonium chloride, diallyl dimethyl ammonium chloride, and 2-hydroxy-3-methacryloxypropyl trimethylammonium chloride.

Commercially available materials can be also used as the cationic polymerization surfactant. For example, Acryester DMC (registered trademark) made by Mitsubishi Rayon Co., Ltd., Acryester DML60 (registered trademark) made by Mitsubishi Rayon Co., Ltd., and C-1615 made by Dai-Ichi Kogyo Seiyaku Co., Ltd. can be used here.

The above examples of the cationic polymerization surfactant can be used singly or in combination.

Meanwhile, the anionic polymerization surfactant is a surfactant having an anionic group, a polymerization group, and a hydrophobic group.

Examples of the anionic group included in the anionic polymerization surfactant may include: a sulfonate anionic group (-SO₃⁻), a sulfinate anionic group (-RSO₂-, where R is an alkyl group having 1 to 12 carbon atoms, a phenyl group, or modification thereof), a carboxylic acid anionic group (-COO-). One of the above examples is preferably selected.

As the hydrophobic group included in the anionic polymerization surfactant, a hydrophobic group similar to one included in the cationic polymerization surfactant can be used.

As the polymerization group included in the anionic polymerization surfactant, a polymerization group similar to one included in the cationic polymerization surfactant can be used.

Examples of the anionic polymerization surfactant include: anionic allyl acid derivatives described in JP-A-49-46291, JP-A-1-24142, and JP-A-62-104802; anionic propenyl derivatives described in JP-A-62-221431; anionic acrylic acid derivatives described in JP-A-62-34947 and JP-A-55-11525; and anionic itaconic acid derivatives described in JP-A-46-34898 and JP-A-51-30284.

The compound including the third structure units and/or the fourth structure units preferably includes a repeated structure units derived from a hydrophobic monomer as well as any of the above-mentioned polymerization surfactants.

The hydrophobic monomer at least includes a hydrophobic group and a polymerization group in their molecular structures. Including such a hydrophobic monomer can increase the hydrophobicity and polymerization of the polymer film. It is therefore possible to improve the mechanical strength and durability of the polymer film.

Out of the two groups, as the hydrophobic group, at least one of an alphatic hydrocarbon group, an alicyclic hydrocarbon group, and an aromatic hydrocarbon group may be used, for example.

Examples of the alphatic hydrocarbon group may include a methyl group, an ethyl group, and a propyl group. Examples of the alicyclic hydrocarbon group may include a cyclohexyl group, a dicyclopentenyl group, a dicyclopentanyl group, and an isobornyl group. Examples of the aromatic hydrocarbon group may include a benzyl group, a phenyl group, and a naphthyl group.

Also, a polymerization group similar to the above-mentioned polymerization group to which the first structure units and the second structure units are each bonded can be used here. The polymerization group is polymerized in the process to manufacture the solar cell 10, which will be described later, to become the protection film 12.

Examples of the hydrophobic monomer may include: styrene, methylstyrene, dimethylstyrene, chlorostyrene, dichlorostyrene, bromostyrene, p-chloromethylstyrene, divinylbenzene, and other styrene derivatives; methyl acrylate, ethyl acrylate, n-butyl acrylate, butoxyethyl acrylate, benzyl acrylate, phenyl acrylate, phenoxyethyl acrylate, cyclohexyl acrylate, dicyclopentanyl acrylate, dicyclopentenyl acrylate, dicyclopentenyloxyethyl acrylate, tetrahydrofurfuryl acrylate, isobornyl acrylate, and other monofunctional acrylic acid esters; methyl methacrylate, ethyl methacrylate, n-butyl methacrylate, 2-ethylhexyl methacrylate, butoxymethyl methacrylate, benzyl methacrylate, phenyl methacrylate, phenoxyethyl methacrylate, cyclohexyl methacrylate, dicyclopentanyl methacrylate, dicyclopentenyl methacrylate, dicyclopentenyloxyethyl methacrylate, tetrahydrofurfuryl methacrylate, isobornyl methacrylate, and other monofunctional methacrylic acid esters; allylbenzene, allyl-3-cyclohexanepropionate, 1-allyl-3,4-dimethoxybenzene, allyl phenoxyacetate, allyl phenylacetate, allyl cyclohexane, polycarboxylic acid allyl, and other allyl compounds; fumaric acid esters, maleic acid esters, and itaconic acid esters; N-substituted maleimide, cyclic olefin, and other monomers having a radical polymerization group. The hydrophobic monomer that meets the above-described requirements of a desired amount can be selected appropriately.

The protection film 12 can be manufactured as follows, for example.

(2-5) On the substrate 20, the first electrode 30, the electron transport layer 40, the second film 2, the third film 3, and the first film 4 are provided in the same manner as in the processes (1) through (2-3).

(2-6) The third structure units are oriented to the surface of the third film 3.

The third structure units can be oriented by making a liquid containing the third structure units come in contact with the third film 3, for example.

It is therefore possible to extremely highly control the alignment of the third structure units in a way that the polar groups 11' of the third structure units are placed face to face with the electric charges the second structure units in the third film 3 have. Consequently, the third structure units are oriented to the surface of the third film 3 to form a micelle.

A method similar to one in the first embodiment can be used to make the liquid containing the third structure units come in contact with the third film 3.

Also, a solvent (or a dispersion medium) similar to one in the first embodiment can be used to prepare the liquid containing the third structure units.

(2-7) The fourth structure units are oriented to the third structure units that have been oriented to the surface of the third film 3.

The fourth structure units can be oriented by making a liquid containing the fourth structure units come in contact with the third structure units, for example.

Accordingly, the polymerization group and the hydrophobic group 7d bonded to the fourth structure units are disposed to face the polymerization group and the hydrophobic group 7c bonded to the third structure units. Consequently, the fourth structure units are oriented to the third structure units on its side remote from the third film 3 to form a micelle.

A method similar to one in the first embodiment can be used to make the liquid containing the fourth structure units come in contact with the third structure units.

Also, a solvent (or a dispersion medium) similar to one in the first embodiment can be used to prepare the liquid containing the fourth structure units.

(2-8) Between the third structure units and the fourth structure units that have been oriented, the protection film 12 is provided.

The protection film 12 can be provided by making a liquid containing a polymerization initiator come in contact with the third structure units and the fourth structure units, for example.

Consequently, a polymerization reaction occurs at least one of the following to make a polymer: between the polymerization group bonded to the third structure units and the polymerization group bonded to the fourth structure units; between each polymerization group bonded to the third structure units; and between each polymerization group bonded to the fourth structure units. Thus the protection film 12 can be provided as shown in Fig. 8.

(2-9) As required, the substrate 20 provided with the protection film 12 is dried.

A drying method similar to one in the process (2-4) can be used.

An electronic apparatus according to one embodiment of the invention includes the solar cell 10.

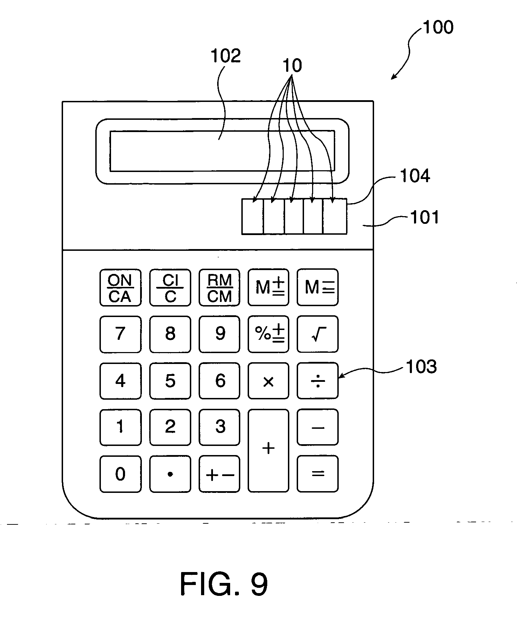

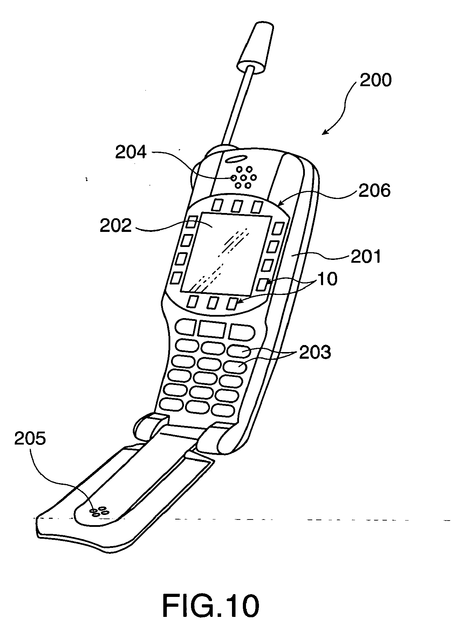

Referring now to Figs. 9 and 10, the electronic apparatus according to one embodiment of the invention will be described.

Fig. 9 is a plan view showing a calculator to which the electronic apparatus according to one embodiment of the invention is applied. Fig. 10 is a perspective view showing a cellular phone (including a personal handyphone system) to which the electronic apparatus according to one embodiment of the invention is applied.

A calculator 100 shown in Fig. 9 includes a body 101, a display 102 on the upper (front) surface of the body 101, a plurality of operation buttons 103, and a solar cell units 104.

In the structure shown in Fig. 9, five solar cells 10 are arranged tandemly in the solar cell units 104.

A cellular phone 200 shown in Fig. 10 includes a body 201, a display 202 on the front surface of the body 201, a plurality of operation buttons 203, an earpiece 204, a mouthpiece 205, and a solar cell units 206.

In the structure shown in Fig. 10, a plurality of solar cells 10 are arranged tandemly in a way that they surround the display 202 in the solar cell units 206.

While the embodiments of the method for manufacturing a photoelectric conversion element, the photoelectric conversion element, and the electronic apparatus are described herein, the invention is not limited to these embodiments.

For example, each element of the photoelectric conversion element and the electronic apparatus may be replaced with any other elements having similar functions.

The photoelectric conversion element according to one embodiment of the invention is not limited to solar cells, and is also applicable to various elements (light-receiving elements) that receive and convert light into electrical energy, such as optical sensors and switches.

Furthermore, light may be incident on the photoelectric conversion element according to one embodiment of the invention in a reverse direction, which is different from the direction shown in the drawings. In other words, light may be incident in any direction.

Furthermore, the polarities of the electric charges and the polar groups shown in the drawings are given by way of example, and they may have opposite polarities.

### Working Examples

Specific working examples related to the embodiments of the invention will now be described. It is understood that the examples are not intended to limit the invention.

### 1. Manufacturing of Solar Cell

### First Example

The solar cell (photoelectric conversion element) as shown in Fig. 1 was manufactured in the following manner.

(A1) A soda-glass substrate of 30.0 mm by 35.0 mm with a thickness of 1.0 mm was prepared. The soda-glass substrate was dipped in an 85-degree-Celsium cleaning solution (mixture of sulfuric acid and hydrogen peroxide solution) for cleaning to cleanse its surface.

(A2) On the upper surface of the soda-glass substrate, an FTO electrode (first electrode) of 30.0 mm by 35.0 mm with a thickness of 1.0 µm was provided by vapor deposition.

(A3) On the upper surface (whole) of the FTO electrode, a titanium dioxide layer (electron transport layer) was provided in the following manner.

(A3-1) A titanium dioxide powder composed of a mixture of rutile titanium dioxide and anatase titanium dioxide powders was prepared. The mean diameter of the titanium dioxide powder was 40 nm. The mix ratio of the rutile titanium dioxide and anatase titanium dioxide powders was 60:40 by weight.

(A3-2) Distilled water and 2-propanol were added to the titanium dioxide powder, so that the content of the powder became 3 wt%. They were agitated to prepare a dispersion liquid.

(A3-3) The dispersion liquid was applied on the FTO electrode by an application method. It was dried and then burned at 450 degrees Celsius for one hour to complete the titanium dioxide layer.

(A4) On the upper surface (whole) of the titanium dioxide layer, a photoelectric conversion layer was provided in the following manner.

(A4-1) An acetonitrile solution was prepared by adding the compound (first structure units) represented by the formula (2) to acetonitrile, so that the content of the compound became 1 x 10⁻³ mol/L. The acetonitrile solution was then applied on the titanium dioxide layer by an application method to provide a second film.

(A4-2) Another acetonitrile solution was prepared by adding the compound (second structure units) represented by the formula (3) to another acetonitrile, so that the content of the compound became 1 x 10⁻³ mol/L. The acetonitrile solution was then applied on the second layer by an application method to provide a third film.

(A4-3) Sodium persulfate (polymerization initiator) was added to still another acetonitrile and agitated to provide a first film, which completed the photoelectric conversion layer. Agitation was performed at 70 degrees Celsius for five hours.

(A4-4) The soda-glass substrate provided with the photoelectric conversion layer was freeze-dried at a cooling temperature of -45 degrees Celsius and a pressure of 9 Pa.

(A5) The soda-glass substrate provided with the FTO electrode, the titanium dioxide layer, and the photoelectric conversion layer was placed on a hot plate that had been heated to 80 degrees Celsius. Onto the upper surface of the photoelectric conversion layer, an acetonitrile solution of CuI (material to form a hole transport layer) was dropped and dried. This process was repeated to form a multilayer to provide a CuI layer (hole transport layer).

In the acetonitrile solution, tetrapropylammonium iodide was added, so that its content became 1 x 10⁻³ wt%.

Also, cyanoresin (cyanoethylated compound) was added as a binder of CuI to the acetonitrile solution. Here, the ratio of CuI and cyanoresin was made to be 97:3 by weight.

(A6) On the upper surface of the CuI layer, a platinum electrode (second electrode) of 30.0 mm by 30.0 mm with a thickness of 0.1 mm was provided by vapor deposition.

### Second Example

A solar cell was manufactured in the same manner as in the first example, except that the compound represented by the formula (10) was used instead of the compound represented by the formula (2) in the process (A4-1).

### Third Example

A solar cell was manufactured in the same manner as in the first example, except that the compound represented by the formula (11) was used instead of the compound represented by the formula (2) in the process (A4-1), and the compound represented by the formula (2) was used instead of the compound represented by the formula (3) in the process (A4-2).

### Fourth Example

A solar cell was manufactured in the same manner as in the first example, except that the following processes were added after the process (A4-3).

(A4-5) An acetonitrile solution was prepared by adding Adeka Reasoap SE-10N (made by Asahi Denka Co., Ltd.) as the compound (third structure units) represented by the formula (31a) to acetonitrile, so that the content of the compound became 1 x 10⁻³ mol/L. The acetonitrile solution was then applied on the third layer by an application method to provide a liquid film.

(A4-6) Another acetonitrile solution was prepared by adding Adeka Reasoap SR-10 (made by Asahi Denka Co., Ltd.) as the compound (fourth structure units) represented by the formula (34) to another acetonitrile, so that the content of the compound became 1 x 10⁻³ mol/L. The acetonitrile solution was then applied on the liquid film, provided in the process (A4-5), by an application method.

(A4-7) Sodium persulfate (polymerization initiator) was added to still another acetonitrile and agitated to provide a protection film, which completed the photoelectric conversion layer. Agitation was performed at 70 degrees Celsius for five hours.

(A4-8) The soda-glass substrate provided with the photoelectric conversion layer was freeze-dried at a cooling temperature of -45 degrees Celsius and a pressure of 9 Pa.

### Fifth Example

A wet-type dye-sensitized solar cell (photoelectric conversion element) was manufactured in the following manner.

(B1) A soda-glass substrate of 30.0 mm by 35.0 mm with a thickness of 1.0 mm was prepared. The soda-glass substrate was dipped in an 85-degree-Celsium cleaning solution (mixture of sulfuric acid and hydrogen peroxide solution) for cleaning to cleanse its surface.

(B2) On the upper surface of the soda-glass substrate, an FTO electrode (first electrode) of 30.0 mm by 35.0 mm with a thickness of 1.0 µm was provided by vapor deposition.

(B3) In an area of 30.0 mm by 30.0 mm on the upper surface of the FTO electrode, a titanium dioxide layer (electron transport layer) was provided in the following manner.

(B3-1) A titanium dioxide powder composed of a mixture of rutile titanium dioxide and anatase titanium dioxide powders was prepared. The mean diameter of the titanium dioxide powder was 20 nm. The mix ratio of the rutile titanium dioxide and anatase titanium dioxide powders was 60:40 by weight.

(B3-2) Distilled water and 2-propanol were added to the titanium dioxide powder, so that the content of the powder became 3 wt%. They were agitated to prepare a dispersion liquid.

(B3-3) The dispersion liquid was applied on the FTO electrode by an application method. It was dried and then burned at 450 degrees Celsius for one hour to complete the titanium dioxide layer.

(B4) On the upper surface (whole) of the titanium dioxide layer, a photoelectric conversion layer was provided in the following manner.

(B4-1) An acetonitrile solution was prepared by adding the compound (first structure units) represented by the formula (2) to acetonitrile, so that the content of the compound became 1 x 10⁻³ mol/L. The acetonitrile solution was then applied on the titanium dioxide layer by an application method to provide a second film.

(B4-2) Another acetonitrile solution was prepared by adding the compound (second structure units) represented by the formula (3) to another acetonitrile, so that the content of the compound became 1 x 10⁻³ mol/L. The acetonitrile solution was then applied on the second layer by an application method to provide a third film.

(B4-3) Sodium persulfate (polymerization initiator) was added to still another acetonitrile and agitated to provide a first film, which completed the photoelectric conversion layer. Agitation was performed at 70 degrees Celsius for five hours.

(B4-4) The soda-glass substrate provided with the photoelectric conversion layer was freeze-dried at a cooling temperature of -45 degrees Celsius and a pressure of 9 Pa.

(B5) Around an area on the FTO electrode provided with no titanium dioxide film, a spacer with a thickness of about 30.0 µm was attached. On top of the spacer, a glass substrate of 30.0 mm by 30.0 mm with a thickness of 1.0 µm was attached.

(B6) Between the two glass substrates that had been provided through the process (B5), an iodine solution with an acetonitrile solvent was injected.

In the iodine solution, tetrapropylammonium iodide was added, so that its content became 1 x 10⁻³ wt%.

### Sixth Example

A wet-type dye-sensitized solar cell was manufactured in the same manner as in the fifth example, except that the following processes were added after the process (B4-3).

(B4-5) An acetonitrile solution was prepared by adding the compound (third structure units) represented by the formula (31a) to acetonitrile, so that the content of the compound became 1 x 10⁻³ mol/L. The acetonitrile solution was then applied on the third layer by an application method to provide a liquid film.

(B4-6) Another acetonitrile solution was prepared by adding the compound (fourth structure units) represented by the formula (34) to another acetonitrile, so that the content of the compound became 1 x 10⁻³ mol/L. The acetonitrile solution was then applied on the liquid film, provided in the process (B4-5), by an application method.

(B4-7) Sodium persulfate (polymerization initiator) was added to still another acetonitrile and agitated to provide a protection film, which completed the photoelectric conversion layer. Agitation was performed at 70 degrees Celsius for five hours.

(B4-8) The soda-glass substrate provided with the photoelectric conversion layer was freeze-dried at a cooling temperature of ―45 degrees Celsius and a pressure of 9 Pa.

### First Comparative Example

A solar cell was manufactured in the same manner as in the first example, except that the process (A4) was modified as follows.

(A4) On the upper surface (whole) of the titanium dioxide layer, a photoelectric conversion layer was provided in the following manner.

(A4-1) The soda-glass substrate provided with the FTO electrode and the titanium dioxide layer was dipped in a saturated ethanol solution of ruthenium tris bipyridyl (organic dye), taken out from the ethanol solution, and then dried naturally to vaporize ethanol.

(A4-2) The soda-glass substrate that had been taken out was dried with a clean oven at 80 degrees Celsius for half an hour, and then left for one night. Consequently, the photoelectric conversion layer was provided along the outer surface of the titanium dioxide layer and the inner surface of a pore thereof.

### Second Comparative Example

A wet-type dye-sensitized solar cell was manufactured in the same manner as in the fifth example, except that the process (B4) was modified as follows.

(B4) On the upper surface (whole) of the titanium dioxide layer, a photoelectric conversion layer was provided in the following manner.

(B4-1) The soda-glass substrate provided with the FTO electrode and the titanium dioxide layer was dipped in a saturated ethanol solution of ruthenium tris bipyridyl (organic dye), taken out from the ethanol solution, and then dried naturally to vaporize ethanol.

(B4-2) The soda-glass substrate that had been taken out was dried with a clean oven at 80 degrees Celsius for half an hour, and then left for one night. Consequently, the photoelectric conversion layer was provided along the outer surface of the titanium dioxide layer and the inner surface of a pore thereof.

### 2. Evaluation

Each solar cell manufactured in the examples and comparative examples was irradiated with light from an artificial sunlight lamp (irradiating light intensity: AM1.5, 100 W/m²) in a direction orthogonal to the substrate to compare the photoelectric conversion efficiency of each solar cell.

As a result, it was proved that the solar cells manufactured in the examples (the photoelectric conversion element according an aspect of the invention) excelled in photoelectric conversion efficiency over the photoelectric conversion elements manufactured in the comparative examples.
The foregoing description has been given by way of example only and it will be appreciated by a person skilled in the art that modifications can be made without departing from the scope of the present invention.

## Claims

1. A multilayer structure, comprising:
a base;
a first film;
a second film including a plurality of first structure units; and
a third film including a plurality of second structure units;
the first film being disposed between the second film and the third film,
the second film being disposed between the base and the first film,
the first film being chemically bonded to one of at least one first structure units out of the plurality of first structure units and at least one second structure units out of the plurality of second structure units, and
electron transfer occurring between the second film and the third film in response to energy applied.

2. The multilayer structure according to Claim 1, the first film having a function to restrict an electron moving from one of the second film and the third film to the other film as the electron transfer from moving from the other film to the one film.

3. The multilayer structure according to Claim 2, at least one of the plurality of first structure units and the plurality of second structure units being chemically bonded to the first film.

4. The multilayer structure according to any one of Claims 1-3, the bonding being a covalent bonding.

5. The multilayer structure according to any one of Claims 1-4, the base including at least one of a semiconductor material and a metal material.

6. The multilayer structure according to any one of Claims 1-5, the plurality of first structure units being bonded to the base with a bonding group therebetween.

7. The multilayer structure according to any one of Claims 1-6, the first film being provided by polymerizing at least one of a polymerization group bonded to one of the plurality of first structure units and a polymerization group bonded to one of the second structure units.

8. The multilayer structure according to any one of Claims 1-7, further comprising:
a fourth film;
the plurality of second structure units being disposed between the fourth film and the first film.

9. The multilayer structure according to Claim 8, further comprising:
a plurality of polar groups;
the fourth film being disposed between the plurality of polar groups and the plurality of second structure units.

10. The multilayer structure according to any one of Claims 1-9, one of each of the plurality of first structure units and each of the plurality of second structure units including a metal complex.

11. A photoelectric conversion element, comprising:
the multilayer structure according to any one of Claims 1-10,.

12. A photoelectric conversion element, comprising:
the multilayer structure any one of Claims 1-10;
the base doing one of the following: providing at least one of the plurality of first structure units and the plurality of second structure units with an electron in response to light applied to the photoelectric conversion element, and electron in response to light applied to the photoelectric conversion element, and receiving an electron from at least one of the plurality of first structure units and the plurality of second structure units in response to light applied to the photoelectric conversion element.

13. The photoelectric conversion element according to Claim 11, the base including an electrode.

14. The photoelectric conversion element according to Claim 11, the base including a carrier transport part between the electrode and the plurality of first structure units.

15. An electronic apparatus, comprising:
the photoelectric conversion element according to Claim 11.
